# EUROPÄISCHE PATENTSCHRIFT

(11) **EP 0 316 706 B1**
(45) Veröffentlichungstag und Bekanntmachung des Hinweises auf die Patenterteilung: **23.02.1994**
(21) Anmeldenummer: 88118537.5
(22) Anmeldetag: 08.11.1988
(51) Int. Cl.: C07C 217/42, C07D 295/08, G03F 7/004

(54) **Polymerisierbare Verbindungen und dieses enthaltendes durch Strahlung polymerisierbares Gemisch**
Polymerizable compounds and mixture polymerizable by radiation containing them
Composés polymérisables et mélange polymérisable par radiation les contenant

(30) Priorität: 16.11.1987 DE 3738864
(43) Veröffentlichungstag der Anmeldung: 24.05.1989
(73) Patentinhaber: HOECHST AKTIENGESELLSCHAFT, 65926 Frankfurt am Main (DE)
(72) Erfinder: Gersdorf, Joachim, Dr. Dipl.-Chem., D-6200 Wiesbaden (DE); Rode, Klaus, Dr. Dipl.-Chem., D-6200 Wiesbaden (DE)

(56) Entgegenhaltungen:
- DE-A- 3 331 157
- US-A- 3 759 807
- CHEMICAL ABSTRACTS, Band 107, Teil 6, 10. August 1987, Seite 660, Zusammenfassung Nr. 49611s, Columbus, Ohio, US; & JP-A-62 00 950

## Beschreibung

Die Erfindung betrifft neue polymerisierbare Verbindungen mit mindestens zwei Acryl- oder Alkacrylsäureestergruppen im Molekül sowie ein durch Strahlung, insbesondere Licht, polymerisierbares Gemisch, das diese Verbindungen enthält.

Photopolymerisierbare Gemische, die als polymerisierbare Verbindungen Acryl- und/oder Methacrylsäureester enthalten, sind bekannt. Es sind auch photopolymerisierbare Gemische bekannt, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten. Derartige synergistisch wirkende Gemische sind z. B. in den DE-A 26 02 419, 22 51 048 und 33 31 157 und in der US-A 3 759 807 beschrieben. Ein Nachteil dieser Gemische, die niedermolekulare Amine enthalten, besteht darin, daß sie eine geringere Lagerstabilität aufweisen, da die Amine, insbesondere aus dünnen Schichten, leicht ausschwitzen bzw. verdunsten können.

In der JP-A 50/129 214 wird ein photopolymerisierbares Gemisch beschrieben, das als polymerisierbare Verbindung einen Tetra(meth)acrylsäureester eines N,N,N',N'-Tetrahydroxyalkyl-alkylendiamins enthält. Die tetrafunktionelle Verbindung dient als Vernetzungsmittel.

Es sind auch Gemische bekannt, die als Vernetzer Triechanolamintrimethacrylat enthalten und z. B. in Chem. Abstr. 86 (1977), 30443q und 95 (1981), 220 727n beschrieben sind. Auch diese Verbindungen neigen bei längerer Lagerung und bei erhöhter Umgebungstemperatur dazu, aus der Schicht zu diffundieren und zu verdampfen.

In der älteren, nicht vorveröffentlichten EP-A 287 818 werden höhermolekulare polymerisierbare Acryl- und Alkacrylsäureester vorgeschlagen, die im Molekül mindestens eine Aminogruppe und mindestens eine Urethangruppe enthalten.

Aufgabe der Erfindung war es, polymerisierbare Acryl-oder Alkacrylsäureester bereitzustellen, die sich zur Verwendung in durch Strahlung polymerisierbaren Gemischen, insbesondere photopolymerisierbaren Gemischen eignen und die polymerisierbare Gemische hoher Strahlungsempfindlichkeit ergeben, die diese auch nach längerer Lagerung beibehalten.

Erfindungsgemäß wird eine Verbindung der allgemeinen Formel I 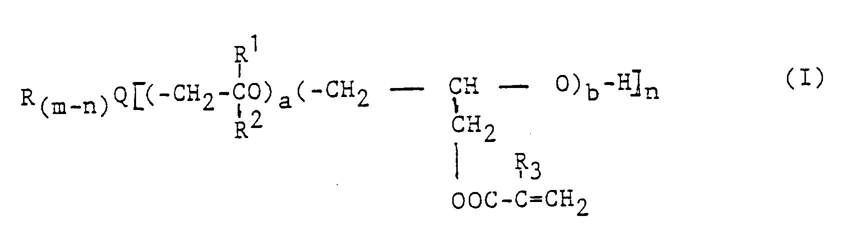
vorgeschlagen, worin
- Q: -Ń-, -Ń-E-Ń- oder 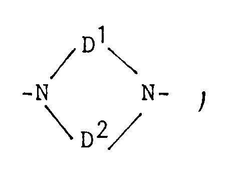
- R: eine Alkyl-, Hydroxyalkyl- oder Arylgruppe,
- R¹ und R²: jeweils ein Wasserstoffatom, eine Alkylgruppe oder Alkoxyalkylgruppe,
- R³: ein Wasserstoffatom, eine Methyl- oder Ethylgruppe,
- D¹ und D²: jeweils eine gesättigte Kohlenwasserstoffgruppe mit 1 bis 5 Kohlenstoffatomen,
- E: eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen, eine heterocyclische aromatische Gruppe mit 5 oder 6 Ringgliedern oder eine Gruppe der Formel II 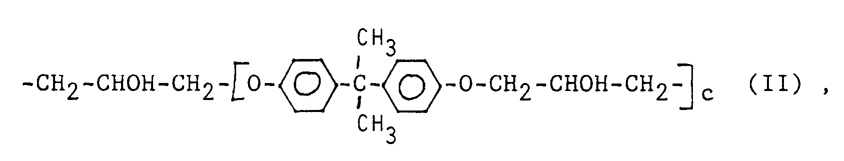
- a und b: ganze Zahlen von 1 bis 4,
- c: eine ganze Zahl von 1 bis 3,
- m: je nach Wertigkeit von Q 2, 3 oder 4 und
- n: eine ganze Zahl von 1 bis m
bedeutet, wobei alle Reste gleicher Definition untereinander gleich oder verschieden sein können.

Erfindungsgemäß wird ferner ein durch Strahlung polymerisierbares Gemisch vorgeschlagen, das als wesentliche Bestandteile
a) ein polymeres Bindemittel,
b) einen Acryl- oder Alkacrylsäureester eines mehrwertigen Alkohols und
c) eine Verbindung oder eine Verbindungskombination, die unter Einwirkung aktinischer Strahlung die Polymerisation der Verbindung b) zu initiieren vermag,
enthält.

Das erfindungsgemäße Gemisch ist dadurch gekennzeichnet, daß der Acryl- oder Alkacrylsäureester eine Verbindung der vorstehend angegebenen allgemeinen Formel I ist.

Erfindungsgemäß wird weiterhin ein durch Strahlung polymerisierbares Aufzeichnungsmaterial mit einem Schichtträger und einer durch Strahlung polymerisierbaren Schicht vorgeschlagen, die aus einem Gemisch der vorstehend genannten Zusammensetzung besteht.

Wenn in der Verbindung der allgemeinen Formel I mehr als ein Rest R oder mehr als ein Rest des in eckigen Klammern angegebenen Typs an die zentrale Gruppe Q gebunden ist, so können diese Reste untereinander verschieden sein.

Verbindungen, in denen alle Substituenten von Q polymerisierbare Reste sind, d. h. in denen m = n ist, werden im allgemeinen bevorzugt.

Im allgemeinen ist in nicht mehr als einem Rest a = 0, vorzugsweise ist a = 1.

Wenn R eine Alkyl- oder Hydroxyalkylgruppe ist, hat diese im allgemeinen 2 bis 8, vorzugsweise 2 bis 4 Kohlenstoffatome. Der Arylrest R kann im allgemeinen ein- oder zweikernig, bevorzugt einkernig, und gegebenenfalls durch Alkyl- oder Alkoxygruppen mit bis zu 5 Kohlenstoffatomen oder durch Halogenatome substituiert sein.

Wenn R¹ und R² Alkyl- oder Alkoxyalkylgruppen sind, können diese 1 bis 5 Kohlenstoffatome enthalten.

R³ ist bevorzugt ein Wasserstoffatom oder eine Methylgruppe, insbesondere eine Methylgruppe.

D¹ und D² können gleich oder verschieden sein und bilden zusammen mit den beiden Stickstoffatomen einen gesättigten heterocyclischen Ring mit 5 bis 10, vorzugsweise 6 Ringgliedern.

Wenn E eine Alkylengruppe ist, hat diese im allgemeinen 2 bis 6, vorzugsweise 2 bis 4 Kohlenstoffatome, als Arylengruppe ist es bevorzugt eine Phenylengruppe. Als cycloaliphatische Gruppen werden Cyclohexylengruppen, als aromatische Heterocyclen solche mit N oder S als Heteroatomen und mit 5 oder 6 Ringgliedern bevorzugt.

Die polymerisierbaren Verbindungen der Formel I mit Q = N und n = m werden hergestellt, indem Acryl- oder Alkacrylsäureglycidylester in bekannter Weise mit Hydroxyalkylaminen umgesetzt werden. Die Umsetzung kann analog zu der in der DE-A 29 27 933 oder der DE-B 18 00 462 beschriebenen Umsetzung von Glycidyl(meth)acrylat mit Alkoholen durchgeführt werden.

Die als Ausgangsstoffe verwendeten Hydroxyalkylamine sind bekannt oder analog bekannten Verbindungen herzustellen. Beispiele sind Verbindungen, die durch Anlagerung von Ethylenoxid bzw. von höheren Alkylenoxiden an Ammoniak oder Amine entstehen; z. B. Triethanolamin, N-Alkyl-N,N-di(hydroxyalkyl)amine, Diethanolamin, Tris-(2-hydroxypropyl)amin oder Tris-(2-hydroxybutyl)amin.

Die bevorzugten polymerisierbaren Verbindungen der Formel I mit

Q = -Ń-E-Ń- und n = 4

werden analog den polymerisierbaren Verbindungen mit Q = N hergestellt. Die als Ausgangsstoffe verwendeten Tetrahydroxyalkyl-alkylendiamine sind bekannt oder analog zu bekannten Verbindungen herzustellen. Beispiele sind Verbindungen, die durch Anlagerung von Ethylenoxid oder höheren Alkylenoxiden an Diaminoverbindungen entstehen, z. B. an Ethylendiamin und andere Alkylendiamine mit bis zu 12, vorzugsweise bis zu 6 Kohlenstoffatomen im Alkylenrest, p-Phenylendiamin, Benzidin, Diaminopyridine, Diaminopyrimidine, Diaminopurine.

Die polymerisierbaren Verbindungen der Formel I mit 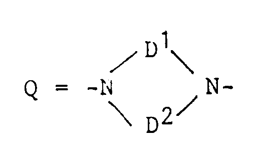
werden analog den oben beschriebenen polymerisierbaren Verbindungen hergestellt. Die als Ausgangsstoffe verwendeten N-Hydroxyalkylheterocyclen sind bekannt oder analog zu bekannten Verbindungen herzustellen. Beispiele sind Umsetzungsprodukte des Ethylenoxids mit Piperazin, 1,4-Diazacycloheptan, 1,10-Diaza-4,7,13,16-tetraoxacyclooctadecan. Insbesondere wird Piperazin eingesetzt, da es der einfachste Vertreter dieser Verbindungsgruppe ist.

Ein wesentlicher Vorteil der erfindungsgemäßen Verbindungen besteht darin, daß sie, insbesondere diejenigen mit m = n, für die sehr hohe Lichtempfindlichkeit der damit erhaltenen photopolymerisierbaren Gemische verantwortlich sind. Ein weiterer Vorteil, der besonders auch gegenüber den bekannten strukturähnlichen polymerisierbaren Verbindungen mit tertiären Aminogruppen im Molekül, z. B. Triethanolamintrimethacrylat, gilt, ist die wesentlich geringere Neigung zur Diffusion oder Verdunstung aus photopolymerisierbaren Schichten.

Den erfindungsgemäßen Verbindungen können mit Vorteil auch herkömmliche polymerisierbare Verbindungen, die zwei oder mehr polymerisierbare Acryl- oder Methacrylsäureestergruppen enthalten, zugesetzt werden, wobei selbstverständlich zu beachten ist, daß durch diese die durch Verwendung der neuen polymerisierbaren Verbindungen erzielten, oben erläuterten Vorteile nicht zu stark herabgesetzt werden. Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen.

Der Mengenanteil der Schicht an Monomeren beträgt im allgemeinen etwa 10 bis 80, vorzugsweise 20 bis 60 Gew.-%.

Als Bindemittel können eine Vielzahl löslicher organischer Polymerer Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid, Polybutadien, Polyisopren, Isopren-Styrol-Blockcopolymere und andere Elastomere, sowie Mischpolymerisate der Monomeren, die die aufgezählten Homopolymerisate bilden.

Mit Vorteil werden auch Bindemittel verwendet, die wasserunlöslich, aber in wäßrig-alkalischen Lösungen löslich oder mindestens quellbar sind, da sich Schichten mit solchen Bindemitteln mit wäßrig-alkalischen Entwicklern entwickeln lassen. Derartige Bindemittel können z. B. die folgenden Gruppen enthalten: -COOH, -PO₃H₂, -SO₃H; -SO₂NH-, -SO₂-NH-SO₂- und -SO₂-NH-CO-.

Als Beispiele hierfür seien genannt: Maleinatharze, Polymerisate aus N-(p-Tolyl-sulfonyl)-carbaminsäure-ß-(methacryloyloxy)-ethylester und Mischpolymerisate dieser und ähnlicher Monomerer mit anderen Monomeren, Vinylacetat/Crotonsäure-, Styrol/Maleinsäureanhydrid-, Alkylmethacrylat/Methacrylsäure-Mischpolymerisate und Mischpolymerisate aus Methacrylsäure, höheren Alkylmethacrylaten und Methylmethacrylat und/oder Styrol oder Acrylnitril.

Die Menge des Bindemittels beträgt im allgemeinen 20 bis 90, vorzugsweise 30 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind:
Polymerisationsinhibitoren, Wasserstoffdonatoren, Farbstoffe, gefärbte und ungefärbte Pigmente und Weichmacher.

Als aktinische Strahlung soll im Rahmen dieser Beschreibung jede Strahlung verstanden werden, deren Energie mindestens der des kurzwelligen sichtbaren Lichts entspricht. Geeignet ist u. a. sichtbares Licht, langwellige und kurzwellige UV-Strahlung, Laserstrahlung, Elektronen- und Röntgenstrahlung.

Als Photoinitiatoren in dem erfindungsgemäßen Gemisch können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinoxaline ableiten; ferner Trichlormethyl-s-triazine, 2-Halogenmethyl-5-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450 oder Acylphosphinoxidverbindungen, wie sie z. B. in der DE-A 31 33 419 beschrieben sind.

Die Initiatoren werden allgemein in einer Menge von 0,01 bis 10, vorzugsweise von 0,05 bis 4 Gew.-%, bezogen auf die nichtflüchtigen Bestandteile des Gemischs, eingesetzt.

Wenn die Bebilderung mit Elektronenstrahlen durchgeführt wird, sind neben den bekannten für sichtbares und nahes UV-Licht empfindlichen Photoinitiatoren auch solche geeignet, deren Absorptionsbereiche im kurzwelligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß man die Materialien besser lagerfähig machen kann. Als Beispiele für derartige Starter sind Tribrommethyl-phenylsulfon, 2,2',4,4',6,6'-Hexabromdiphenylamin, Pentabromethan, 2,3,4,5-Tetrachloranilin, Pentaerythrittetrabromid, Chlorterphenylharze oder chlorierte Paraffine zu nennen.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet.

Die detaillierte Beschreibung der Erfindung beschrankt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, besonders Flexodruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Druckformen und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen. Ebenso ist es für die Herstellung von Trockenresist geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen, der mechanisch abziehbar oder entwicklerlöslich sein kann.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen bzw. das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösemittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250_{/}um und darüber) werden vorteilhaft durch Extrudieren oder Verpressen als selbsttragende Folie hergestellt, welche dann ggf. auf einen Träger laminiert wird. Im Falle von Trockenresist werden Lösungen des Gemischs auf transparente Träger aufgebracht und getrocknet. Die lichtempfindlichen Schichten - Dicke etwa zwischen 10 und 100_{/}um - werden dann gleichfalls zunächst zusammen mit dem temporären Träger auf das gewünschte Substrat auflaminiert.

Die Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, oder mit schwach alkalischen wäßrigen Lösungen, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Darin stehen Gewichtsteile (Gt) und Volumteile (Vt) im Verhältnis von g zu ccm. Prozent-und Mengenverhältnisse sind, wenn nichts anderes angegeben ist, in Gewichtseinheiten zu verstehen.

### Beispiel 1

In einem Dreihalskolben mit Rührer, Rückflußkühler und Thermometer werden 11,4 Gt Triethanolamin in 60 Vt Butanon gelöst. Dieser Lösung werden unter Rühren 0,6 Gt Natrium zugegeben. Nach Auflösung des Natriums werden 32,2 Gt Glycidylmethacrylat, gelöst in 40 Vt Butanon, innerhalb von 2 Stunden bei einer Badtemperatur von 60° C zugetropft. Nach weiteren 2 Stunden bei 60° C wird auf Raumtemperatur abgekühlt, und 0,2 Gt 2,6-Di-tert-butyl-4-methylphenol werden zugegeben. Mit einer dem Natrium äquivalenten Menge wäßriger Salzsäure wird ausgeschüttelt. Anschließend wird die Lösung noch zweimal mit Wasser ausgeschüttelt, über Natriumsulfat getrocknet und am Rotationsverdampfer bei 50° C eingeengt.
Ausbeute: 26,1 Gt N(CH₂CH₂OCH₂CHOHCH₂OOC-C(CH₅)=CH₂)₃
Analyse: N ber.: 2,43 %; gef.: 2,4 %
Eine Lösung von
3,92 Gt des oben beschriebenen Umsetzungsprodukts aus Triethanolamin und Glycidylmethacrylat,
3,92 Gt eines Copolymeren aus Methylmethacrylat und Methacrylsäure mit dem mittleren Molekulargewicht 35000 und der Säurezahl 86,
0,07 Gt 9-Phenylacridin,
0,084 Gt des Azofarbstoffs aus 2,4-Dinitro-6-chlor-benzoldiazoniumsalz und 2-Methoxy-5-acetylamino-N-cyanoethyl-N-hydroxyethylanilin und
0,07 Gt 4-Dimethylamino-4'-methyldibenzalaceton in
51,4 Vt Butanon
wird gerührt, filtriert und auf einer Plattenschleuder auf elektrolytisch aufgerauhtes und anodisiertes Aluminium aufgeschleudert. Die Platten werden 2 Minuten bei 90° C getrocknet; das Schichtgewicht beträgt 3,5 g/m². Nach Aufbringen einer Deckschicht wird die Photopolymerschicht unter einer kombinierten Negativvorlage, bestehend aus einem Halbton-Stufenkeil, Strichelementen und 60er und 120er Punktrasterelementen mit einem 8 kW-Xenon-Kopiergerät belichtet. Die belichtete Platte wird mit dem folgenden Entwickler 1 Minute entwickelt:
3 Gt Natriummetasilikat x 9 H₂O,
0,03 Gt Kokosfettamin-Ethylenoxid-Reaktionsprodukt,
96,97 Gt vollentsalztes Wasser.

Dann wird mit 1 %iger Phosphorsäure fixiert und abschließend mit schwarzer Fettfarbe eingefärbt. Es wird eine Flachdruckplatte mit guter Auflösung der Bildstellen erhalten.

### Beispiel 2

Eine Lösung von
12 Gt eines Terpolymeren aus n-Hexylmethacrylat, Methacrylsäure und Styrol (60:30:10) mit einem mittleren Molekulargewicht von 35000 und der Säurezahl 195,
8 Gt des in Beispiel 1 beschriebenen Umsetzungsprodukts aus Triethanolamin und Glycidylmethacrylat,
0,2 Gt des in Beispiel 1 angegebenen Azofarbstoffs und
0,2 Gt 9-Phenylacridin in
40 Gt Butanon
wird auf eine biaxial verstreckte und thermofixierte Polyethylenterephthalatfolie der Stärke 25_{/}um so aufgeschleudert, daß nach dem Trocknen bei 100° C eine Schichtdicke von 25_{/}um erhalten wird. Man erhält eine Trockenresistfolie, die mit einer handelsüblichen Laminiervorrichtung bei 120° C auf eine mit 35_{/}um starker Kupferfolie kaschierte Phenoplast-Schichtstoffplatte laminiert und 30 Sekunden mit einem 8 kW-Xenon-Kopiergerät bildmäßig belichtet wird. Als Vorlage dient eine Strichvorlage mit Linienbreiten und Abständen bis herab zu 80_{/}um. Nach der Belichtung wird die Polyesterfolie abgezogen und die Schicht durch Besprühen mit einer 1 %igen Natriumcarbonatlösung innerhalb 2 Minuten entwickelt. Die Platte wird dann in eine 15 %ige Ammoniumperoxydisulfatlösung von 50° C getaucht. Die den unbelichteten Teilen der Schicht entsprechenden Kupferflächen werden weggeätzt, und die zurückbleibende belichtete Schicht wird mit Trichlorethan entfernt, wonach ein einwandfreies negatives Kupferbild der ursprünglichen Bildvorlage erhalten wird.

### Beispiel 3

In einem Dreihalskolben mit Rührer, Rückflußkühler und Thermometer werden 23,6 Gt N,N,N',N'-Tetrakis-(2-hydroxyethyl)-ethylendiamin in 150 Gt Butanon gelöst. Dieser Lösung werden unter Rühren 0,68 Gt Natrium zugesetzt. Nach Auflösung des Natriums werden 56,8 Gt Glycidylmethacrylat, gelöst in 70 Gt Butanon, innerhalb von 2 Stunden bei einer Badtemperatur von 60° C zugetropft. Nach weiteren 2 Stunden bei 60° C wird auf Raumtemperatur abgekühlt, und 0,3 Gt 2,6-Di-tert.butyl-4-methyl-phenol werden zugegeben. Mit einer dem Natrium äquivalenten Menge wäßriger Salzsäure wird ausgeschüttelt. Anschließend wird noch zweimal mit 10 %iger wäßriger Natriumcarbonatlösung und zweimal mit Wasser ausgeschüttelt, über Natriumsulfat getrocknet und am Rotationsverdampfer bei 50° C eingeengt.
Ausbeute: 52,3 Gt X₂N-CH₂CH₂-NX₂; X=-CH₂CH₂OCH₂CHOHCH₂OOCC(CH₃)=CH₂
Analyse: N-Gehalt: ber.: 3,48 % gef.: 3,7 %
Von einer Lösung aus
12 Gt des in Beispiel 2 beschriebenen Terpolymeren,
8 Gt des oben beschriebenen Monomeren,
0,2 Gt 9-Phenylacridin und
0,2 Gt des in Beispiel 1 angegebenen Azofarbstoffs in
40 Gt Butanon
wird analog zu Beispiel 2 eine Trockenresistfolie hergestellt und verarbeitet. Es wird ein einwandfreies negatives Kupferbild der ursprünglichen Bildvorlage erhalten.

### Beispiel 4

In einem Dreihalskolben mit Rührer, Rückflußkühler und Thermometer werden 14,9 Gt Triethanolamin in 75 Gt Butanon gelöst. Dieser Lösung werden unter Rühren 0,76 Gt Natrium zugesetzt. Nach Auflösung des Natriums werden 127,9 Gt Glycidylmethacrylat, gelöst in 125 Gt Butanon, innerhalb von 2 Stunden bei einer Badtemperatur von 60° C zugetropft. Nach weiteren 2 Stunden bei 60° C wird auf Raumtemperatur abgekühlt, und 0,3 Gt 2,6-Di-tert.butyl-4-methyl-phenol werden zugegeben. Mit einer dem Natrium äquivalenten Menge wäßriger Salzsäure wird ausgeschütcelt. Anschließend wird noch zweimal mit 10 %iger wäßriger Natriumcarbonatlösung und zweimal mit Wasser ausgeschüttelt, über Natriumsulfat getrocknet und am Rotationsverdampfer bei 50° C eingeengt.
Ausbeute: 118,2 Gt

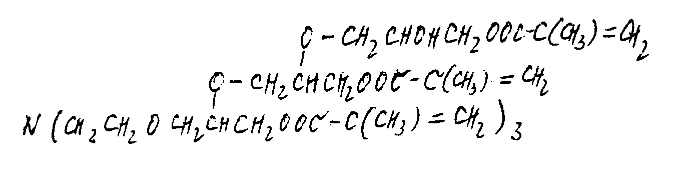

Analyse: N-Gehalt ber.: 1,0 % gef.: 1,2 %
Mit einer Lösung aus
3,92 Gt des oben beschriebenen Umsetzungsprodukts aus 1 mol Triethanolamin und 9 mol Glycidylmethacrylat,
3,92 Gt des in Beispiel 1 angegebenen Copolymeren,
0,07 Gt 9-Phenylacridin,
0,084 Gt des in Beispiel 1 angegebenen Azofarbstoffs und
0,07 Gt 4-Dimethylamino-4'-methyldibenzalaceton in
51,4 Vt Butanon
wird analog zu Beispiel 1 eine photopolymerisierbare Schicht auf Aluminium mit einem Schichtgewicht von 3,7 g/m² hergestellt. Nach Belichtung und Entwicklung wie in Beispiel 1 wird eine Flachdruckplatte mit guter Auflösung der Bildstellen erhalten.

### Beispiel 5

Eine Lösung von
90 Gt eines Styrol/Isopren/Styrol-Dreiblock-Copolymeren mit 15 % Styrolgehalt,
8 Gt des in Beispiel 3 beschriebenen Monomeren,
2 Gt Benzildimethylketal und
0,3 Gt 2,6-Di-tert.butyl-4-methylphenol in
100 Gt Toluol
wird auf eine 125_{/}um dicke, biaxial verstreckte und thermofixierte Polyesterfolie unter Verwendung eines Metallrahmens zu einer 6 mm dicken Schicht gegossen. Nach Verdunsten des Toluols wird auf die freie Oberfläche der erhaltenen 3 mm dicken festen Photopolymerschicht eine mit einer Haftschicht versehene 125_{/}um dicke, biaxial verstreckte und thermofixierte Polyesterfolie aufgelegt und das Mehrschichtenelement in einer Plattenpresse bei 110° C unter Verwendung von 2,7 mm dicken Distanzstücken 5 Minuten gepreßt. Nach dem Abstreifen der unbeschichteten Polyesterfolie wird die Photopolymerschicht mit einem handelsüblichen UV-A-Flachbelichter (Spektralbereich 320-400 nm:Intensität des UV-A Streulichtes 14 mW/cm²) 10 Minuten ohne Vorlage durch die verbliebene Polyesterfolie und danach 30 Minuten bildmäßig von der freien Schichtseite aus belichtet. Nach dem Auswaschen der nichtbelichteten Bildstellen mit Tetrachlorethen wird eine elastische Hochdruckform mit guter Reliefausbildung (Relieftiefe 1,5 mm) und einer Härte von 48 Shore-A erhalten.

### Beispiel 6

In einem Dreihalskolben mit Rührer, Rückflußkühler und Thermometer werden 19,1 Gt Triisopropanolamin in 75 Gt Butanon gelöst. Dieser Lösung werden unter Rühren 0,78 Gt Natrium zugegeben. Nach Auflösung des Natriums werden 42,7 Gt Glycidylmethacrylat, gelöst in 75 Gt Butanon, innerhalb von 2 Stunden bei einer Badtemperatur von 60° C zugetropft. Nach weiteren 2 Stunden bei 60° C wird auf Raumtemperatur abgekühlt, und 0.3 Gt 2,6-Di-tert.butyl-4-methylphenol werden zugegeben. Mit einer dem Natrium äquivalenten Menge wäßriger Salzsäure wird ausgeschüttelt. Anschließend wird noch zweimal mit 10 %iger wäßriger Natriumcarbonatlösung und zweimal mit Wasser ausgeschüttelt, über Natriumsulfat getrocknet und am Rotationsverdampfer bei 50° C eingeengt.
Ausbeute: 42,1 Gt

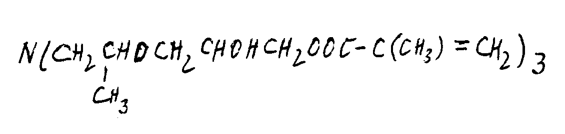

Mit einer Lösung aus
3,92 Gt des oben beschriebenen Umsetzungsprodukts aus Triisopropanolamin und Glycidylmethacrylat,
3,92 Gt des in Beispiel 1 angegebenen Copolymeren,
0,07 Gt 9-Phenylacridin,
0,084 Gt des in Beispiel 1 angegebenen Azofarbstoffs und
0,07 Gt 4-Dimethylamino-4'-methyldibenzalaceton in
51,4 Vt Butanon
wird wie in Beispiel 1 eine Photopolymerschicht auf Aluminium mit einem Schichtgewicht von 3,7 g/m² hergestellt. Nach Belichtung und Entwicklung analog Beispiel 1 wird eine Flachdruckplatte mit guter Auflösung der Bildstellen erhalten.

### Beispiel 7

In einem Dreihalskolben mit Rührer, Rückflußkühler und Thermometer werden 4,6 Gt Diethanolamin und 20 Gt eines Epoxidharzes aus Bisphenol A und Glycidylchlorid mit dem Epoxid-Äquivalentgewicht 455 (Beckopox EP 301) in 50 Gt Butanon eine Stunde bei 60° C gerührt. Nach Zugabe von 0,5 Gt Natriumhydrid werden 12,5 Gt Glycidylmethacrylat, gelöst in 20 Gt Butanon, zugetropft und eine Stunde bei 60° C gerührt. Nach Abkühlung auf Raumtemperatur werden 0,2 g 2,6-Di-tert.butyl-4-methylphenol und eine dem Natriumhydrid äquivalente Menge wäßriger Salzsäure zugegeben. Anschließend wird noch zweimal mit 10 %iger wäßriger Natriumcarbonatlösung und zweimal mit Wasser ausgeschüttelt, über Natriumsulfat getrocknet und am Rotationsverdampfer bei 50° C eingeengt.
Ausbeute: 24,1 Gt
(CH₂=C(CH₃)-COOCH₂CHOHCH₂OCH₂CH₂)₂N-E-N(CH₂CH₂OCH₂CHOHCH₂OOCC(CH₃)=CH₂)₂ E= Rest gemäß Formel II
Mit einer Lösung aus
3,92 Gt des oben beschriebenen Umsetzungsproduktes aus Epoxidharz, Diethanolamin und Glycidylmethacrylat,
3,92 Gt des in Beispiel 1 angegebenen Copolymeren,
0,07 Gt 9-Phenylacridin,
0,084 Gt des in Beispiel 1 angegebenen Azofarbstoffs und
0,07 Gt 4-Dimethylamino-4'-methyldibenzalaceton in
51,4 Vt Butanon
wird analog zu Beispiel 1 eine Photopolymerschicht auf Aluminium mit einem Schichtgewicht von 3,6 g/m² hergestellt. Nach Belichtung und Entwicklung wie in Beispiel 1 wird eine Flachdruckplatte mit guter Auflösung der Bildstellen erhalten.

## Patentansprüche

1. Verbindung der allgemeinen Formel I 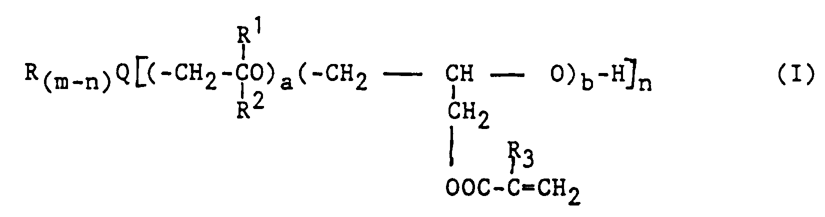 worin
Q -Ń-, -Ń-E-Ń- oder 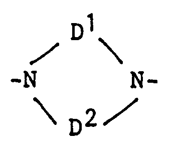
R eine Alkyl-, Hydroxyalkyl- oder Arylgruppe,
R¹ und R² jeweils ein Wasserstoffatom, eine Alkylgruppe oder Alkoxyalkylgruppe,
R³ ein Wasserstoffatom, eine Methyl- oder Ethylgruppe,
D¹ und D² jeweils eine gesättigte Kohlenwasserstoffgruppe mit 1 bis 5 Kohlenstoffatomen,
E eine gesättigte Kohlenwasserstoffgruppe mit 2 bis 12 Kohlenstoffatomen, eine cycloaliphatische Gruppe mit 5 bis 7 Ringgliedern, die ggf. bis zu zwei N-, O- oder S-Atome als Ringglieder enthält, eine Arylengruppe mit 6 bis 12 Kohlenstoffatomen, eine heterocyclische aromatische Gruppe mit 5 oder 6 Ringgliedern oder eine Gruppe der Formel II 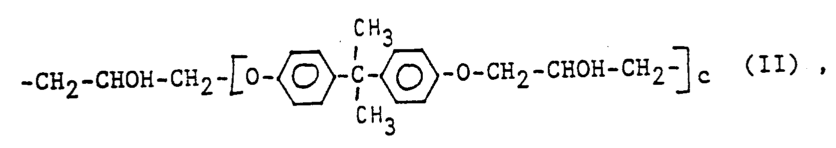
a und b ganze Zahlen von 1 bis 4,
c eine ganze Zahl von 1 bis 3,
m je nach Wertigkeit von Q 2, 3 oder 4 und
n eine ganze Zahl von 1 bis m
bedeutet, wobei alle Reste gleicher Definition untereinander gleich oder verschieden sein können.

2. Verbindung gemäß Anspruch 1, dadurch gekennzeichnet, daß n = m ist.

3. Verbindung gemäß Anspruch 1, dadurch gekennzeichnet, daß E eine gesättigte Alkylengruppe mit 2 bis 4 Kohlenstoffatomen ist.

4. Verbindung gemäß Anspruch 1, dadurch gekennzeichnet, daß R³ = CH₃ ist.

5. Verbindung gemäß Anspruch 1, dadurch gekennzeichnet, daß a = 1 ist.

6. Durch Strahlung polymerisierbares Gemisch, das als wesentliche Bestandteile
a) ein polymeres Bindemittel,
b) einen Acryl- oder Alkacrylsäureester eines mehrwertigen Alkohols und
c) eine Verbindung oder eine Verbindungskombination, die unter Einwirkung aktinischer Strahlung die Polymerisation der Verbindung b) zu initiieren vermag,
enthält, dadurch gekennzeichnet, daß der Acryl- oder Alkacrylsäureester eine Verbindung der Formel I gemäß Anspruch 1 ist.

7. Durch Strahlung polymerisierbares Gemisch nach Anspruch 6, dadurch gekennzeichnet, daß das Bindemittel wasserunlöslich und in wäßrig-alkalischen Lösungen löslich ist.

8. Durch Strahlung polymerisierbares Gemisch nach Anspruch 6, dadurch gekennzeichnet, daß es, bezogen auf die nichtflüchtigen Bestandteile des Gemischs, 10 bis 80 Gew.-% Acryl- oder Alkacrylsäureester, 20 bis 90 Gew.-% polymeres Bindemittel und 0,01 bis 10 Gew.-% des durch Strahlung aktivierbaren Polymerisationsinitiators enthält.

9. Durch Strahlung polymerisierbares Aufzeichnungsmaterial mit einem Schichtträger und einer durch Strahlung polymerisierbaren Schicht, dadurch gekennzeichnet, daß die durch Strahlung polymerisierbare Schicht aus einem Gemisch gemäß Anspruch 6 besteht.

## Claims

1. A compound of the general formula I 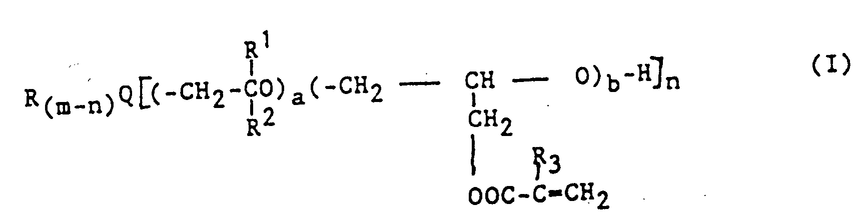 in which
Q denotes -Ń-, -Ń-E-Ń- or 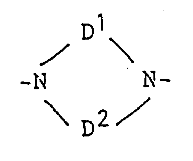
R denotes an alkyl, hydroxyalkyl or aryl group,
R¹ and R² each denote a hydrogen atom, an alkyl group or an alkoxyalkyl group,
R³ denotes a hydrogen atom, a methyl group or an ethyl group,
D¹ and D² each denote a saturated hydrocarbon group having 1 to 5 carbon atoms,
E denotes a saturated hydrocarbon group having 2 to 12 carbon atoms, a cycloaliphatic group having 5 to 7 ring members which optionally contains up to two N, O or S atoms as ring members, an arylene group having 6 to 12 carbon atoms, a heterocyclic aromatic group having 5 or 6 ring members or a group of the formula II 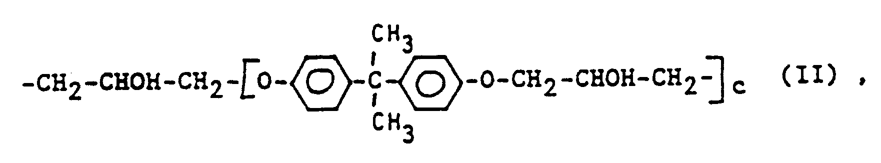
a and b denote integers from 1 to 4,
c denotes an integer from 1 to 3,
m denotes 2, 3 or 4, depending on the valency of Q, and
n denotes an integer from 1 to m,
where all radicals of the same definition may be identical to or different from one another.

2. A compound as claimed in claim 1, characterized in that n = m.

3. A compound as claimed in claim 1, characterized in that E is a saturated alkylene group having 2 to 4 carbon atoms.

4. A compound as claimed in claim 1, characterized in that R³ is CH₃.

5. A compound as claimed in claim 1, characterized in that a is 1.

6. A radiation-polymerizable mixture which contains, as essential components,
a) a polymeric binder,
b) an acrylate or alkacrylate of a polyhydric alcohol, and
c) a compound or a combination of compounds which is capable of initiating polymerization of compound b) under the action of actinic radiation,
characterized in that the acrylate or alkacrylate is a compound of the formula I as claimed in claim 1.

7. A radiation-polymerizable mixture as claimed in claim 6, characterized in that the binder is insoluble in water, but soluble in aqueous alkaline solutions.

8. A radiation-polymerizable mixture as claimed in claim 6, characterized in that it contains, relative to the nonvolatile components of the mixture, 10 to 80 % by weight of acrylate or alkacrylate, 20 bis 90 % by weight of polymeric binder and 0.01 to 10 % by weight of the radiation-activatable polymerization initiator.

9. A radiation-polymerizable recording material having a layer support and a radiation-polymerizable layer, characterized in that the radiation-polymerizable layer comprises a mixture as claimed in claim 6.

## Revendications

1. Composé de formule générale I 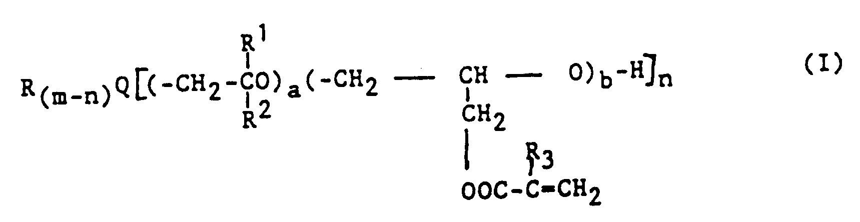 dans laquelle les différents symboles représentent:
Q -Ń-, -Ń-E-Ń- ou 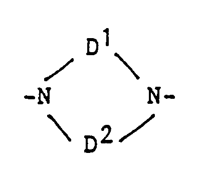
R un groupe alkyle, hydroxyalkyle ou aryle,
R¹ et R² chacun un atome d'hydrogène, un groupe alkyle ou un groupe alcoxyalkyle,
R³ l'atome d'hydrogène ou un groupe méthyle ou éthyle,
D¹ et D² chacun un groupe hydrocarboné saturé en C₁₋₅,
E un groupe hydrocarboné saturé en C₂₋₁₂, un groupe cycloaliphatique comportant de 5 à 7 chaînons, qui renferme éventuellement jusqu'à deux atomes N, O ou S comme chaînons cycliques, un groupe arylène en C₆₋₁₂, un groupe aromatique hétérocyclique pentagonal ou hexagonal, ou un groupe de formule II: 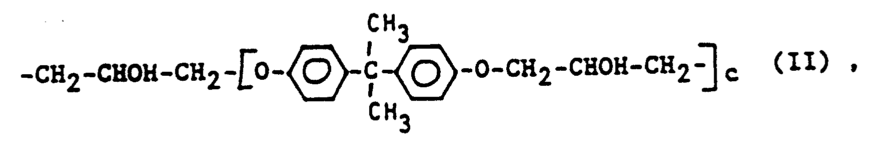
a et b des nombres entiers de 1 à 4,
c un nombre entier de 1 à 3,
m selon la valence de Q: 2, 3 ou 4, et
n un nombre entier de 1 à m,
tous les radicaux de même définition pouvant être identiques ou différents les uns des autres.

2. Composé selon la revendication 1, caractérisé en ce que n = m.

3. Composé selon la revendication 1, caractérisé en ce que E représente un groupe alkylène saturé en C₂₋₄.

4. Composé selon la revendication 1, caractérisé en ce que R³ = CH₃.

5. Composé selon la revendication 1, caractérisé en ce que a = 1.

6. Composition polymérisable par irradiation, qui contient comme constituants principaux:
a) un liant polymère,
b) un ester d'acide acrylique ou alkylacrylique et d'un polyol, et
c) un composé ou une combinaison de composés, qui peut, sous l'effet d'un rayonnement actinique, amorcer la polymérisation du composé b),
caractérisée en ce que l'ester d'acide acrylique ou alkylacrylique est un composé de formule I selon la revendication 1.

7. Composition polymérisable par irradiation selon la revendication 6, caractérisée en ce que le liant est insoluble dans l'eau mais soluble dans les solutions alcalines aqueuses.

8. Composition polymérisable par irradiation selon la revendication 6, caractérisée en ce qu'elle contient, par rapport aux constituants non volatils de la composition, de 10 à 80 % en poids d'ester d'acide acrylique ou alkylacrylique, de 20 à 90 % en poids de liant polymère et de 0,01 à 10 % en poids d'amorceur de polymérisation activable par rayonnement.

9. Matériau d'enregistrement reprographique polymérisable par irradiation comprenant un support de couche et une couche polymérisable par irradiation, caractérisé en ce que la couche polymérisable par irradiation se compose d'une composition selon la revendication 6.
